(19) **Europäisches Patentamt**
**European Patent Office**
**Office européen des brevets**

(11) **EP 4 645 695 A1**

(12) **EUROPEAN PATENT APPLICATION**

(43) Date of publication:
**05.11.2025 Bulletin 2025/45**

(21) Application number: **24173084.5**

(22) Date of filing: **29.04.2024**

(51) International Patent Classification (IPC):
**H03K 17/041** (2006.01)     **H02M 1/00** (2006.01)
**H02M 1/08** (2006.01)        **H02M 3/335** (2006.01)
**H03K 17/06** (2006.01)

(52) Cooperative Patent Classification (CPC):
**H03K 17/04106; H02M 1/0045; H02M 1/08;
H02M 1/32; H02M 1/36; H02M 3/33523;
H03K 2217/0081**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **NXP USA, Inc.
Austin TX 78735 (US)**

(72) Inventors:
• **BOTTAREL, Valeria**
  **5656 AG Eindhoven (NL)**
• **GROPPO, Lorenzo**
  **5656 AG Eindhoven (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **A GATE DRIVER CIRCUIT**

(57) A driver circuit for controlling a high-power switch. The driver circuit comprises a flyback converter having a positive output rail and a negative output. The driver circuit also comprises: a driving stage that is connected between the positive output rail and the negative output rail; a shunt regulator configured to regulate the negative output voltage on the negative output rail based on a difference between the negative output voltage and a target negative voltage value, wherein the shunt regulator is powered by the positive output voltage on the positive output rail; a short-circuit transistor having a conduction channel that is connected between the negative output rail and a ground terminal; and a regulation control circuit configured to: provide a short-circuit control signal to a control terminal of the short-circuit transistor in order to short the negative output rail to the ground terminal until the positive output voltage reaches a positive threshold.

FIG. 3

## Description

## Field

The present disclosure relates to a gate driver circuit, and in particular to an isolated gate driver circuit that is suitable for driving the gate of a high-power switch such as those found in inverters in electric vehicles.

## Summary

According to a first aspect of the present disclosure there is provided a driver circuit for controlling a high-power switch, the driver circuit comprising:

a flyback converter, comprising:

a positive output rail, which is configured to provide a positive output voltage with reference to a ground terminal; and
a negative output rail, which is configured to provide a negative output voltage with reference to the ground terminal;

a driving stage that is connected between the positive output rail and the negative output rail, wherein the driving stage is configured to provide a high-power switch control signal for controlling the state of the high-power switch;
a shunt regulator configured to regulate the negative output voltage on the negative output rail based on a difference between the negative output voltage and a target negative voltage value, wherein the shunt regulator is powered by the positive output voltage on the positive output rail;
a short-circuit transistor having:

a conduction channel that is connected between the negative output rail and the ground terminal, and
a control terminal; and

a regulation control circuit configured to:
provide a short-circuit control signal to the control terminal of the short-circuit transistor in order to short the negative output rail to the ground terminal until the positive output voltage reaches a positive threshold.

Advantageously, such a driver circuit reduce or remove an undershoot in the negative output voltage on the negative output rail.
In one or more embodiments, the positive threshold is sufficient for powering the shunt regulator.
In one or more embodiments, the shunt regulator comprises an error amplifier, which is configured to compare the negative output voltage to the target negative voltage value. The error amplifier may be powered by the positive output voltage on the positive output rail.
In one or more embodiments, the shunt regulator further comprises a shunt transistor, wherein the shunt transistor comprises: a conduction channel that is connected between the negative output rail and the ground terminal; and a control terminal. The error amplifier circuit may be configured to provide a shunt control signal to the control terminal of the shunt transistor, wherein the shunt control signal is representative of the difference between a reference voltage and the negative output voltage.
In one or more embodiments, the shunt transistor is configured to operate in an ohmic mode, having a variable ohmic value that depends on the shunt control signal. The short-circuit transistor may be configured to operate in a low ohmic mode.
In one or more embodiments, the shunt transistor and the short-circuit transistor are implemented as a single transistor.
In one or more embodiments, the single transistor is configured to operate in a low ohmic mode when it receives the short control signal, and is configured to operate in a variable ohmic mode when it receives the shunt control signal.
In one or more embodiments, the regulation control circuit comprises:

a pull up resistor connected between the positive output rail and the control terminal of the short-circuit transistor;
a Zener diode comprising an anode and a cathode, wherein the cathode is connected to the control terminal of the short-circuit transistor and the anode is connected to the negative output rail; and
an internal disable transistor comprising a conduction channel connected between the negative output rail and the control terminal of the short-circuit transistor, and a control terminal configured to receive an internal disable signal.

In one or more embodiments, the regulation control circuit further comprises: an external disable transistor comprising a conduction channel connected between the negative output rail and the control terminal of the short-circuit transistor, and a control terminal configured to receive an external disable signal.
In one or more embodiments, the external disable signal is provided based on a user input.
In one or more embodiments, the regulation control circuit further comprises a current mirror, wherein the current mirror comprises:

a first branch, which includes a resistor in series with the conduction channel of a first internal disable transistor;
a second branch, which includes the conduction channel of a second internal disable transistor;

wherein:

the first branch is connected between the positive output rail and the negative output rail;

the second branch is connected between the positive output rail and the negative output rail;

the conduction channel of the second internal disable transistor is connected between the control terminal of the short-circuit transistor and the negative output rail;

the first and the second internal disable transistors are configured to receive an internal disable signal; and

the time constant of the first branch is less than the time constant of the second branch.

In one or more embodiments, when the driver circuit is switched on, the positive output voltage increases until it reaches a first setpoint threshold, at which time the driver circuit is configured to wait for a user input for defining a value of a second setpoint threshold, wherein after the driver circuit receives the user input, the positive output voltage increases until it reaches the second setpoint threshold.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Fig. 1 shows an example of a gate driver circuit;

Fig. 2 shows example plots of the positive output voltage (VCC), the regulated positive output voltage (VCCREG) and the negative output voltage (VEE) of the gate driver circuit of Fig. 1 at startup;

Fig. 3 shows a gate driver circuit including a short-circuit transistor and a regulation control circuit, according to an embodiment of this disclosure;

Fig. 4 shows a closer view of the shunt regulator, the short transistor and the regulation control circuit of Fig. 3, according to an embodiment of this disclosure;

Fig. 5 shows representative plots of the positive output voltage (VCC) and the negative output voltage (VEE), when using the output driver circuit of Fig. 3, according to one embodiment of the present disclosure;

Fig. 6 shows representative plots of the positive output voltage (VCC) and the negative output voltage (VEE), when using the output driver circuit of Fig. 3, according to a further embodiment of the present disclosure;

Fig. 7 shows an example implementation of a regulation control circuit, which is connected to a short-circuit transistor, according to an embodiment of the present disclosure;

Fig. 8 shows another example implementation of a short-circuit transistor and regulation control circuit according to an embodiment of the present disclosure; and

Fig. 9 shows an example of a current mirror circuit that can be used as part of a regulation control circuit for driving / pulling-up / turning-on the short-circuit switch of any of the embodiments of the present disclosure.

## Detailed Description

Inverters that are used in electric vehicles (EVs), for example, can use isolated gate driver Ics (integrated circuits). These gate driver Ics can include an isolated hysteretic flyback converter to supply its high voltage (HV) side, instead of using an external controller. A HV gate driver which includes an isolated hysteretic flyback converter requires no external isolation, except for the flyback transformer, and no external components for compensation. Feedback from the isolated output voltage to the low voltage side can be accomplished by multiplexing an existing isolated data channel with a command to either drive or not drive the low voltage (LV) side primary switch. The output side of the converter provides a split rail for driving the external power device, which can be accomplished with an integrated shunt regulator.

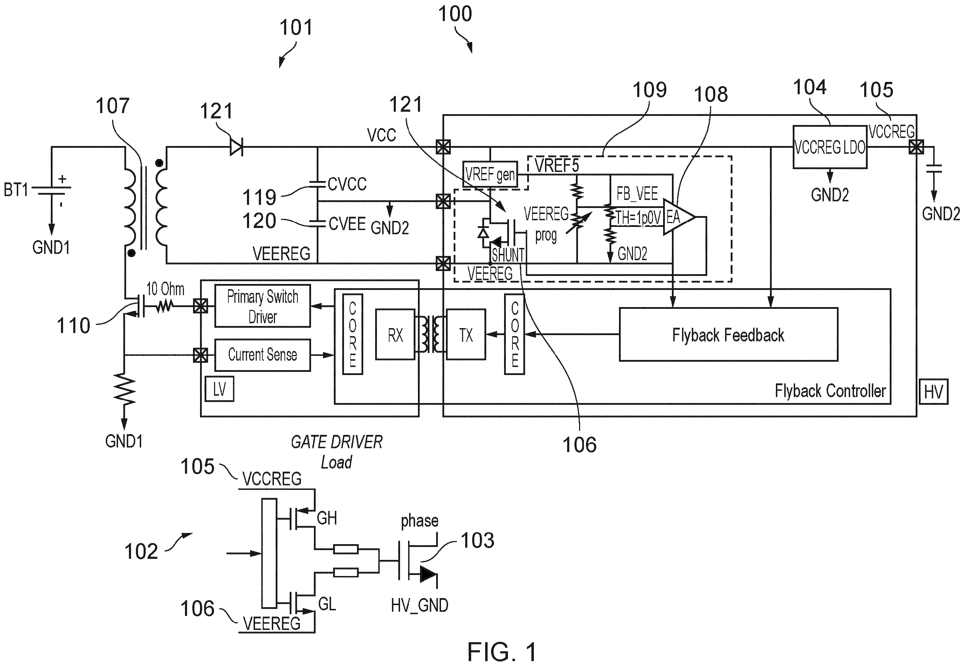

Fig. 1 shows an example of a gate driver circuit 100. The gate driver circuit 100 is for controlling a high-power switch 103, such as the ones that are found in inverters in electric vehicles.

The gate driver circuit 100 includes a flyback converter 101 and a driving stage 102. The flyback converter 101 includes a primary switch 110 and a flyback transformer 107, which has a primary winding and a secondary winding. The flyback transformer 107 provides galvanic isolation between a primary side of the flyback converter 101 and a secondary side of the flyback converter 101. In the example of Fig. 1, the primary side of the flyback converter 101 is a relatively low-voltage side that is connected to a microprocessor. The secondary side of the flyback converter 101 is a relatively high-voltage side that is connected to the driving stage 102 of the high-power switch 103.

The flyback converter 101 includes a positive output rail 105 and a negative output rail 106. The positive output rail 105 is configured to provide a positive output voltage (VCCREG) with reference to a ground terminal (GND2). The negative output rail 106 is configured to provide a negative output voltage (VEEREG) with reference to the ground terminal (GND2). The flyback converter 101 also includes: a positive rail capacitor (CVCC) 119; a negative rail capacitor (CVEE) 120; and a diode 121.

In this example, the positive rail capacitor (CVCC) 119 and the diode 121 are connected in series with each other between a first terminal of the secondary winding of the flyback transformer 107 and the ground terminal (GND2). The negative rail capacitor (CVEE) 120 is connected in series between a second terminal of the secondary winding of the flyback transformer 107 and the ground terminal (GND2).

In an alternative example, the diode 121 can be connected on the VEE side of the secondary winding. That is, the negative rail capacitor (CVEE) 120 and the diode 121 can be connected in series with each other between the second terminal of the secondary winding of the flyback transformer 107 and the ground terminal (GND2), with the polarity of the diode 121 in the reverse direction to that shown in Fig. 1. The positive rail capacitor (CVCC) 119 can be connected in series between the first terminal of the secondary winding of the flyback transformer 107 and the ground terminal (GND2).

The driving stage 102 is connected between the positive output rail 105 and the negative output rail 106. It provides a high-power switch control signal for controlling the state of the high-power switch 103. In this example, the high-power switch 103 is a FET that has a gate terminal for controlling the conductivity of a conduction channel between a source terminal and a drain terminal of the FET. The driving stage 102 therefore provides a gate control signal to the high-power switch 103. In the example of Fig. 1 the gate control signal has a voltage based on either the positive output voltage (VCCREG) on the positive output voltage rail 105 or the negative output voltage (VEEREG) on the negative output voltage rail 106, depending upon whether the high-power switch 103 is to be open or closed.

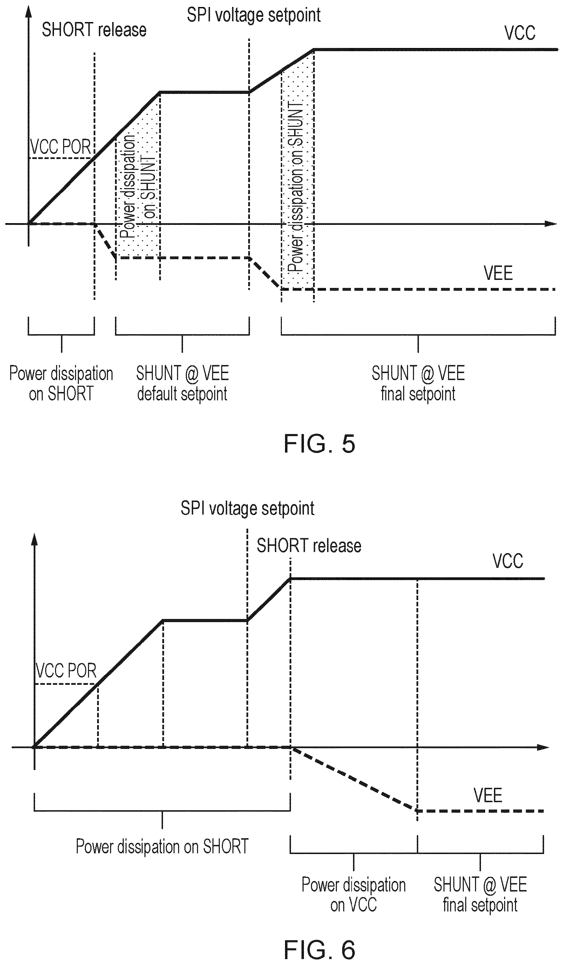

The flyback converter 101 in this example does not use a split secondary winding in the flyback transformer 107; that is, it has a single secondary winding for providing the positive and negative output voltages (VCC and VEE). The flyback converter 101 in this example instead regulates the output voltages (VCC and VEE) by other means which will be explained below. In examples which do use a split secondary winding in the flyback transformer 107, the flyback regulates the positive output voltage (VCC) to ground, and the negative output voltage (VEE) can be obtained based on the winding ratio of the secondary coil. The flyback converter 101 in the example of Fig. 1 provides more flexibility with respect to the desired magnitudes of output voltages (VCC and VEE) because they are not defined by a static quantity such as the winding ratio. It is even possible to dynamically change the regulated output voltages (VCC and VEE) and their ratio during operation of the output driver circuit 100. This will be discussed in more detail later, with reference to Figs. 5 and 6.

The flyback converter 101 includes a low dropout (LDO) regulator 104 associated with the positive output voltage rail 105. The LDO regulator is configured to provide the positive output voltage as a regulated version of the positive voltage (VCC) at the secondary winding of the flyback transformer 107. This regulated version of the positive output voltage is labelled as VCCREG in Fig. 1.

The flyback converter 101 also includes a shunt regulator 109 associated with the negative output voltage rail 106. The shunt regulator 109 is configured to regulate the negative output voltage (VEE) on the negative output rail 106 based on a difference between the negative output voltage (VEE) and a target negative voltage value. This regulated version of the negative output voltage is labelled as VEEREG in Fig. 1.

The shunt regulator 109 is powered by the positive output voltage (VCC) on the positive output rail 105. In this example, the shunt regulator 109 includes an error amplifier circuit 108. The error amplifier circuit 108 is configured to compare the negative output voltage (VEE) to the target negative output voltage value, and to control the operation of a shunt transistor 121 based on the difference between the negative output voltage (VEE) and the target negative output voltage value. This is achieved by the error amplifier 108 providing a regulation error signal to the shunt transistor 121, as will be discussed in more detail below. The error amplifier circuit 108 is powered by the positive output voltage (VCC) on the positive output rail 105, in this example via a reference voltage generator (VREF gen). Since the shunt regulator 109 is powered by the positive output voltage (VCC) on the positive output rail 105, the negative output voltage (VEE) is left unregulated between start-up and the positive output voltage (VCC) reaching a sufficient level to power the shunt regulator 109. It is possible for the negative output voltage (VEE) to undershoot past safe levels while it is unregulated, potentially damaging the high-power switch 103 (which can also be referred to as an output power device).

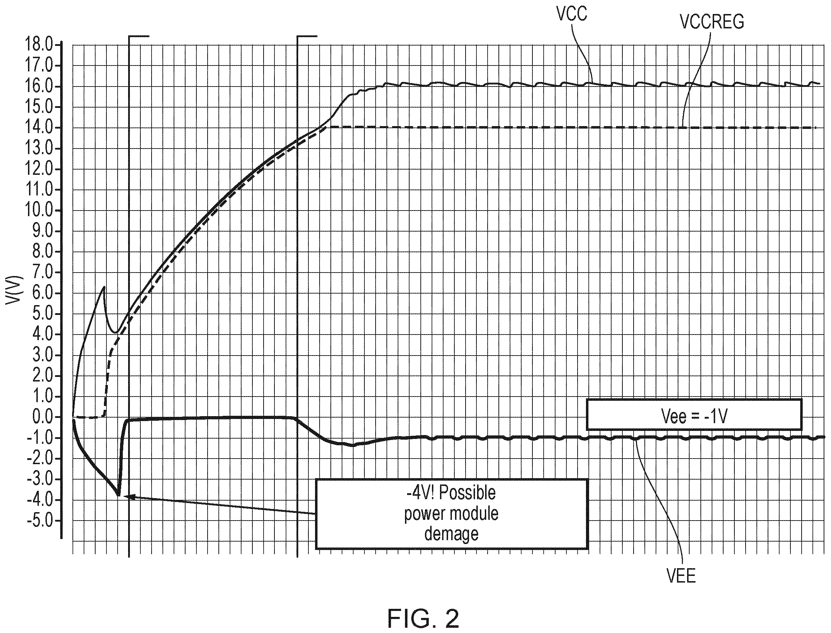

Fig. 2 shows example plots of the positive output voltage (VCC), the regulated positive output voltage (VCCREG) and the negative output voltage (VEE) of the gate driver circuit of Fig. 1 at startup. Voltage is shown on the vertical axis. Time is shown on the horizontal axis.

It can be seen that there is a delay between VCC increasing from 0V and VCCREG starting to increase. In the example of Fig. 1, VCCREG starts to increase when the LDO starts regulating.

In this example, the negative output voltage (VEE) reaches a negative peak of -4V before the shunt regulator is able to activate and regulate the negative output voltage (VEE). This excessive negative voltage may be sufficient to damage other components on the bill of materials, for example the high-power switch or any other components of the power module.

When the positive output voltage (VCC) reaches an operating threshold, it is possible to enable the shunt regulator. In Fig. 1, enabling the shunt regulator includes controlling a switch (the shunt transistor). In any case, the negative output voltage (VEE) can reach a dangerous amplitude of undershoot in an out of control, open-loop start up sequence.

A solution to this issue, which will be described in detail below, is to short the negative output rail to ground as soon as there is sufficient VCC-VEE voltage. In this way, the likelihood of damaging the external device with the high power switch pulled down to VEE through the gate driver stage can be reduced.

Without shorting the negative output rail to ground as soon as possible, during a soft start of the positive output voltage (VCC) to the ground terminal (GND2), the shunt regulator would have to dissipate the unbalance energy due to the unbalance charge QCC=VCC*CVCC, QEE=VEE*CVEE. As is clear, dissipation during start up is higher than what is needed at a steady state of operation. For this reason, to limit temperature increase, a short-circuit transistor connected in parallel with the shunt regulator can be used, with a full gate-source voltage provided during start-up, and operating with an average drain-source voltage which is lower than the final programmed negative output voltage (VEE). In order to be effective and ensure that no dangerous undershoot can occur, a fast turn on is preferred for the short-circuit transistor.

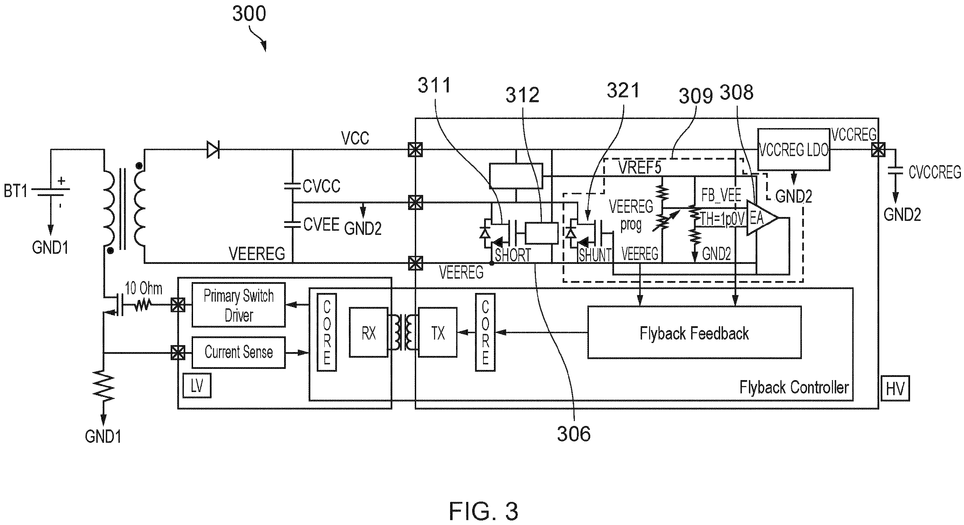

Fig. 3 shows a gate driver circuit 300 including a short-circuit transistor 311 and a regulation control circuit 312, according to an embodiment of this disclosure. In this example, the short-circuit transistor 311 has a conduction channel that is connected between the negative output rail 306 and the ground terminal (GND2). The short-circuit transistor 311 also has a control terminal. The regulation control circuit 312 is configured to provide a short-circuit control signal to the control terminal of the short-circuit transistor 311 in order to short the negative output rail (VEEREG) to the ground terminal until the positive output voltage (VCCREG) reaches a positive threshold. In this example the positive threshold is sufficient for powering the shunt regulator 309. In this way, the short-circuit transistor 311 can be closed by the regulation control circuit 312 when the positive output voltage (VCCREG) is too low to activate the shunt regulator 309. This can advantageously reduce or remove the undershoot in the negative output voltage on the negative output rail (VEEREG) that is shown in Fig. 2.

In the same way as Fig. 1, the shunt regulator 309 includes a shunt transistor 321 and an error amplifier circuit 308. The shunt transistor 321 has: a conduction channel that is connected between the negative output rail (VEEREG) 306 and the ground terminal (GND2). In this example, the shunt transistor 321 is a FET (field effect transistor) with its drain connected to the ground terminal and its source connected to the negative output rail (VEEREG) 306. The shunt transistor 321 also has a control terminal, which in the example of Fig. 3 is its gate. The error amplifier circuit 308 provides a shunt control signal to the control terminal of the shunt transistor 321. The shunt control signal is representative of the difference between a reference voltage and the negative output voltage, as will be discussed in more detail below. In this example, the shunt transistor 321 is configured to operate in an ohmic mode, having a variable ohmic value that depends on the shunt control signal (which can also be referred to as a regulation error signal) provided by the error amplifier 1018. In this way, the shunt transistor 321 can regulate the voltage on the negative output rail (VEEREG) 306. In contrast, the short-circuit transistor 311 is configured to operate in a low ohmic mode. A low ohmic mode can be considered as one with max Vgs (i.e., gate-source voltage).

The shunt regulator 309 is able to finely control the value of the negative output voltage by varying the resistance between the negative output rail 306 (VEEREG) and the ground terminal (GND2). The short-circuit transistor 311 is able to completely short the negative output rail 306 to the ground terminal (GND2) to prevent the voltage on the negative output rail 306 (VEEREG) from undershooting at a time when the shunt regulator 309 is not active. In this way, the short-circuit transistor 311 can support the control of the negative output voltage during startup on the positive output, when the regulation circuitry is not powered and the shunt regulator cannot operate.

As will be discussed below, the regulation control circuit 312 can be an effective and fast driving circuit which is enabled to turn on the short-circuit transistor 311 to limit undershoot on the negative output voltage (VEEREG) and limit the average dissipated power during startup. The regulation control circuit 312 in this example can operate with very low supply voltages, can be fast at activating the short-circuit transistor 311, and can have a low power consumption after a soft start, during normal shunt operation, and when the short-circuit transistor 311 is turned off and the shunt regulator 309 controls the negative output voltage (VEEREG) value.

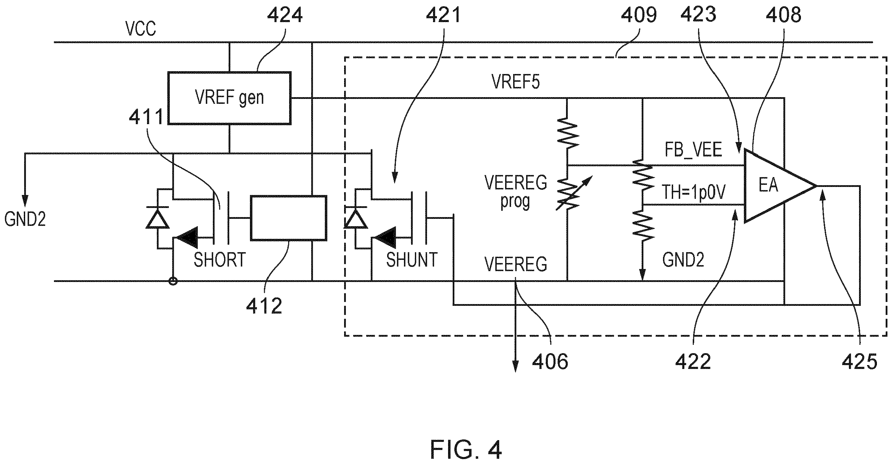

Fig. 4 shows a closer view of the shunt regulator 409, the short transistor 411 and the regulation control circuit 412 of Fig. 3, according to an embodiment of this disclosure.

The error amplifier circuit 408 has a reference input terminal 422, a measurement input terminal 423 and an output terminal 425. The reference input terminal 422 receives a reference voltage, which in this example is a fixed proportion of a reference voltage (VREF5) that is provided by a voltage generator 424. As shown in Fig. 4, this voltage generator 424 receives the positive output voltage on the positive output rail (VCC) and also provides a supply voltage to the error amplifier circuit 408. The measurement input terminal 423 receives a signal representative of the negative output voltage on the negative output rail (VEEREG). In this example, the signal representative of the negative output voltage is provided by a resistive divider that is connected between: the output terminal of the voltage generator 424 (that provides a fixed reference voltage (VREF5); and the negative output voltage (VEEREG). In this way, the voltage difference between VREF5 and VEEREG is dropped across the resistive divider, such that the relative values of the resistors in the resistive divider define the proportion of that voltage that is provided as the signal representative of VEEREG to the measurement input terminal 423. Optionally, one of the resistors in the resistive divider can be a variable resistor, as shown in Fig. 4. This enables the proportion of the voltage dropped across each of the resistors in the resistive divider to be adjusted. When such a variable resistive divider is used, the effect of adjusting the variable resistive divider is to relatively adjust the reference voltage at the reference input terminal 422, thereby adjusting the target negative voltage value that the shunt regulator 409 regulates VEEREG to. Examples in which more than one target negative voltage value can be implemented are described below.

The output terminal 425 of the error amplifier circuit 308 provides a shunt control signal to the shunt transistor 421 based on the difference between the reference voltage (at the reference input terminal 422) and the negative output voltage (as represented by the signal at the measurement input terminal 423). The shunt transistor 421 sets the resistance of its communication channel (between its drain and its source) such that it is proportionate to the magnitude of the shunt control signal.

Fig. 5 shows representative plots of the positive output voltage (VCC) and the negative output voltage (VEE), when using the output driver circuit of Fig. 3, according to one embodiment of the present disclosure. In this embodiment, the short-circuit transistor (SHORT) is controlled such that it shorts the negative output rail (VEE) to the ground terminal from start up until the positive output voltage (VCC) reaches a positive threshold (VCC POR). During this period, power is dissipated on the short-circuit transistor (SHORT), as shown in the figure.

When the positive output voltage (VCC) reaches the positive threshold (VCC POR), the short-circuit transistor (SHORT) is turned off (i.e., opened). This is described as "SHORT release" in the figure. The negative output voltage (VEE) then increases (i.e., it becomes more negative) until it reaches a value defined by an initial setpoint (which is identified as a default setpoint in the figure). This initial setpoint is an example of a first target negative voltage value, which the shunt regulator regulates the negative output voltage (VEE) to. Therefore, the value of the negative output voltage (VEE) is held constant at the initial setpoint by the shunt regulator (SHUNT). This is described as "SHUNT @ VEE default setpoint" in the figure. Initially, while the shunt regulator is active, the positive output voltage (VCC) continues to increase until it reaches an initial setpoint, at which point the LDO regulator regulates VCC to a constant value. During the period when VCC is increasing, power is dissipated on the shunt transistor.

In this embodiment, after the positive output voltage (VCC) and the negative output voltage (VEE) have been held at their respective initial setpoints for a period of time, the setpoints for each output voltage (VCC and VEE) are adjusted to final setpoints. The magnitudes of the final setpoints are greater than the magnitudes of their corresponding initial setpoints. The final setpoint for VEE can be considered as a second target negative voltage value, which the shunt regulator regulates the negative output voltage (VEE) to.

In one example, the final setpoints may be programmed by a user providing input after the output voltages have reached their initial setpoints. These final setpoints can be received via a serial peripheral interface (SPI). It can be said that when the driver circuit is switched on, the positive output voltage (VCC) increases until it reaches a first setpoint threshold, at which time the driver circuit is configured to wait for a user to provide input for defining a value of a second setpoint threshold. After the driver circuit receives the user input, the positive output voltage (VCC) increases until it reaches the second setpoint threshold.

The positive output voltage (VCC) is held at the final positive setpoint voltage by the LDO regulator, and the negative output voltage (VEE) is held at the final negative setpoint voltage by the shunt regulator (SHUNT). This is shown in the figure as "SHUNT @ VEE final setpoint". The negative output voltage (VEE) can reach its final setpoint voltage before the positive output voltage (VCC) reaches its final setpoint voltage, as shown in Fig. 5. In this case, the shunt regulator (SHUNT) dissipates power while VCC is increasing and VEE is held at its final setpoint.

In alternative embodiments, the positive output voltage (VCC) and the negative output voltage (VEE) can rise / fall directly to their final setpoint voltages. That is, without pausing at an initial setpoint voltage for any significant period of time.

Turning now to the shunt regulator in more detail, when it is active, the shunt regulator (SHUNT) is used with a variable gate-source voltage (Vgs) and with a drain-source voltage equal to the negative output voltage (Vds=VEE). The power dissipation on the shunt regulator depends on external parameters (flyback current and negative output voltage setpoint) and can be described by the following equations:

$$P_d = \frac{1}{T} \int v(t) \cdot i(t) \, dt$$

$$P_d = \frac{1}{T} \int VEE \cdot i(t) \, dt$$

$$P_d = VEE \cdot \frac{1}{T} \int i(t) \, dt$$

$$P_d = VEE \cdot I\_flyback_{AVG}$$

Where $P_d$ is the power dissipated, $T$ is the total measurement time, $v(t)$ is the instantaneous voltage, $i(t)$ is the instantaneous current, $t$ is time, $VEE$ is the negative output voltage and $I\_flyback_{AVG}$ is the average current within the flyback converter.

When it is active, the short-circuit transistor (SHORT) is used with a full gate-source voltage (that is, the transistor is operating in a low ohmic mode) and with a drain source voltage of approximately 0V. The power dissipation on the short-circuit transistor can be described by the following equations:

$$P_d = \frac{1}{T} \int v(t) \cdot i(t) \, dt$$

$$P_d = \frac{1}{T} \int R_{ds,ON} \cdot i^2(t) \, dt$$

$$P_d = R_{ds,ON} \cdot \frac{1}{T} \int i^2(t) \, dt$$

$$P_d = R_{ds,ON} \cdot I_{RMS}^2$$

Where $R_{ds,ON}$ is the drain-source resistance of the short-circuit transistor when it is in a low ohmic mode and $I_{RMS}$ is the root-mean-square current in the flyback converter.

Therefore, it is possible to change by design the dissipated power level on the short-circuit transistor by choosing $R_{ds,ON}$.

Fig. 6 shows representative plots of the positive output voltage (VCC) and the negative output voltage (VEE), when using the output driver circuit of Fig. 3, according to a further embodiment of the present disclosure. In this embodiment, the short-circuit transistor (SHORT) is active from start up until the positive output voltage (VCC) reaches its final setpoint voltage. During this period, power is dissipated on the short-circuit transistor (SHORT), as shown in the figure. In this embodiment, the positive output voltage (VCC) behaves in the same way as the positive output voltage shown in Fig. 5. In other embodiments, the positive output voltage may rise directly to its final setpoint voltage. That is, without remaining at an initial setpoint voltage for any significant period of time.

In this embodiment, when the positive output voltage (VCC) reaches its final setpoint voltage, the short-circuit transistor is turned off (labelled as "SHORT release" in the figure) and the negative output voltage (VEE) is able to fall towards its final setpoint voltage and the shunt regulator can take over. During the time in which the negative output voltage (VEE) is falling towards its final setpoint voltage, power is dissipated on the positive output rail (VCC), this is shown in the figure as "Power dissipation on VCC". In this example, this involves implementing an internal load current from VCC to GND to prevent CVCC from charging during flyback operations that are needed in order to charge CVEE so that VEE falls down from GND to its final setpoint. Once the negative output voltage (VEE) reaches its final setpoint voltage, the shunt regulator (SHUNT) holds the value of the negative output voltage (VEE) approximately constant at its final setpoint value, this is shown as "SHUNT @ VEE final setpoint" in the figure.

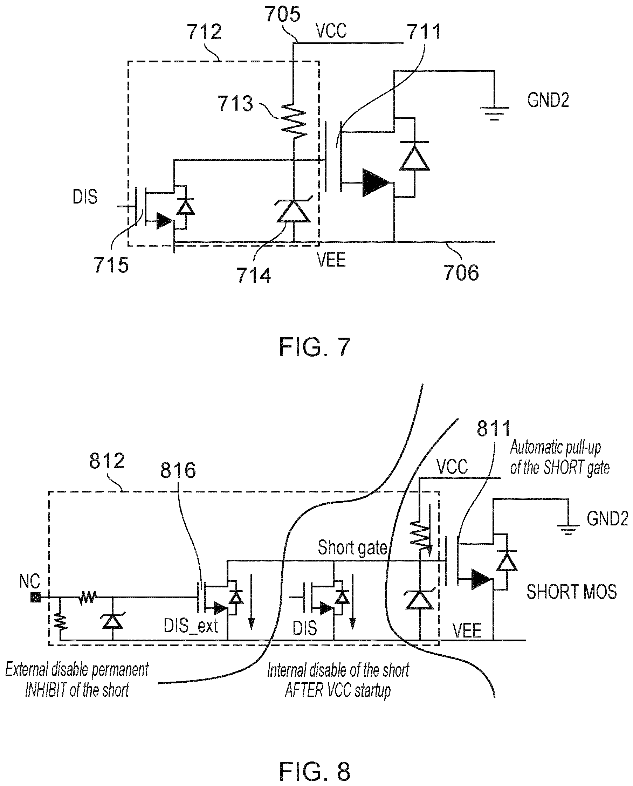

Fig. 7 shows an example implementation of a regulation control circuit 712, which is connected to a short-circuit transistor 711, according to an embodiment of the present disclosure. In this embodiment, the regulation control circuit 712 includes a pull up resistor 713 connected between the positive output rail 705 and the control terminal of the short-circuit transistor 711. The regulation control circuit also includes a Zener diode 714 having an anode and a cathode. The cathode of the Zener diode 714 is connected to the control terminal of the short-circuit transistor 711, and the anode is connected to the negative output rail 706. In this way, the pull up resistor 713 and the Zener diode 714 are connected in series with each other between the positive output rail 705 and the negative output rail 706. A node between the pull up resistor 713 and the Zener diode 714 is connected to the control terminal of the short-circuit transistor 711.

The pull up resistor 713 and the Zener diode 714 provide a voltage at the control terminal of the short-circuit transistor 711 in order to switch it on (i.e., so that it's conduction channel has a low resistance) before the negative output voltage (VEE) can become dangerously negative. In this way, the short-circuit transistor 711 can short circuit the negative output voltage (VEE) to the ground terminal (GND2) at times when the shunt regulator is inactive because VCC is not high enough..

Connecting the pull up resistor 713 and the Zener diode 714 in series with each other between the positive output rail 705 and the negative output rail 706 can advantageously enable the short-circuit transistor 711 to be switched on quickly. For example, if the pull up resistor 713 and the Zener diode 714 were connected in series with each other between the ground terminal (GND2) and the negative output rail 706, then it would take longer for the short-circuit transistor 711 to switch on.

Additionally, the regulation control circuit 712 includes an internal disable transistor 715, which has a conduction channel and a control terminal. The internal disable transistor 715 is for switching off the short-circuit transistor (i.e., such that its conduction channel is high resistance) when it is no longer required because the shunt regulator is able to take over. The conduction channel is connected between the negative output rail 706 and the control terminal of the short-circuit transistor 711. When the internal disable transistor 715 is switched on, it pulls the control terminal of the short-circuit transistor 711 low such that the short-circuit transistor 711 is switched off. The control terminal of the internal disable transistor 715 receives an internal disable signal (DIS). The internal disable signal (DIS) is provided by the output driver circuit and is used to disable the short-circuit transistor 711 when required, for example after the positive output voltage (VCC) has reached a positive threshold as shown in Fig's 5 and 6. This transistor 715 is referred to an "internal" transistor because it receives an internally generated signal for disabling the short-circuit.

Fig. 8 shows another example implementation of a short-circuit transistor 811 and regulation control circuit 812 according to an embodiment of the present disclosure. In this example, in addition to the architecture shown in Fig. 7, the regulation control circuit 812 also includes an external disable transistor 816 comprising a conduction channel connected between the negative output rail 806 and the control terminal of the short-circuit transistor 811, and a control terminal configured to receive an external disable signal (DIS_ext). The external disable signal (DIS_ext) is one that is externally triggered in this example, for instance it can be provided based on a user input. Beneficially, the use of an external disable transistor 816 improves the flexibility of the output driver circuit because the user has more control over how they would like the circuit to perform. Additionally, the external disable transistor 816 provides an emergency bypass for the short-circuit transistor 811 which allows the short-circuit transistor 811 to be switched off if something goes wrong and the output driver circuit is unable to disable the short-circuit transistor 811 itself.

There can be a trade-off with the topology of Fig's 7 and 8 in that: on the one hand, a small RC is beneficial for assisting with a fast turn-on; and on the other hand, a large R can assist with limiting turn-off current. Where, R is the resistance value of the pull up resistor (that is labelled in Fig. 7 as 713), and C is the capacitance of the short-circuit transistor.

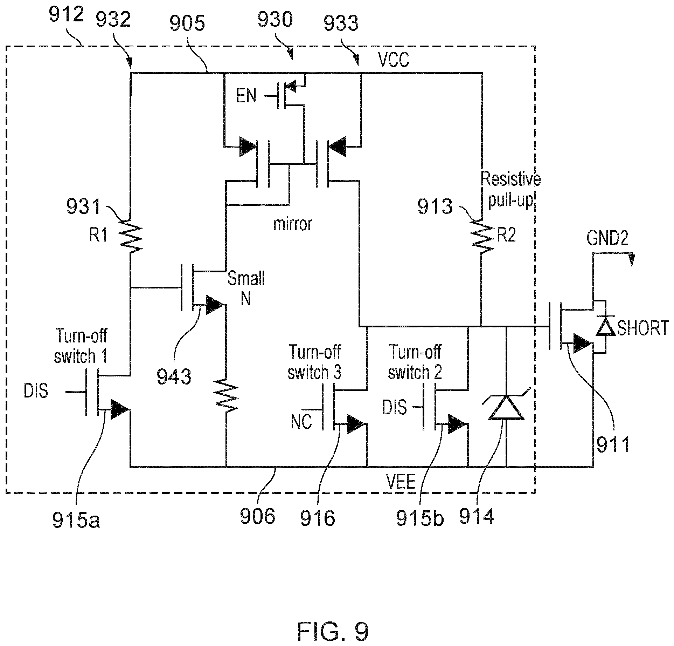

Fig. 9 shows an example of a current mirror circuit 930 that can be used as part of a regulation control circuit 912 of any of the embodiments of the present disclosure. Use of the current mirror circuit 930 can address the trade-off that is identified above in terms of the value of R.

The current mirror circuit 930 includes a first branch 932 and a second branch 933. The first branch 932 is connected between the positive output rail 905 and the negative output rail 906. The second branch 933 is also connected between the positive output rail 905 and the negative output rail 906.

The regulation control circuit 912 of Fig. 9 includes the following components, each of which has been described with reference to an earlier embodiment: a pull up resistor 913; a Zener diode 914; and an external disable transistor 916. The regulation control circuit 912 of Fig. 9 also includes first and second internal disable transistors 915a, and 915b, which are controlled by the same internal disable control signal (DIS in Fig. 9). The first and second internal disable transistors 915a, and 915b of Fig. 9 perform the same functionality as the single internal disable transistor that is provided in the earlier embodiments. The first internal disable transistor 915a is included in the first branch 932 of the current mirror circuit 930. The second internal disable transistor 915b is included in the second branch 933 of the current mirror circuit 930. The conduction channel of the second internal disable transistor 915b is connected between the control terminal of the short-circuit transistor 911 and the negative output rail 906.

The first branch 932 of the current mirror circuit 930 includes a relatively large resistor 931 in series with the conduction channel of the first internal disable transistor 915a. In Fig. 9 there is no resistor included in series with the conduction channel of the second internal disable transistor 915b. However, in other examples there could be a resistor in the second branch 933 that has a lower resistance value than the resistor 931 in the first branch 932. Either way, advantageously the time constant of the first branch 932 is less than the time constant of the second branch 933. This can be considered as providing a split tau (where tau is the time constant).

Therefore, by adding the current mirror circuit 930 of Fig. 9, it is possible to separate and have a small time constant on the first branch 932, having a small current, big pull-up resistance value R1 931, small Cgs (capacitance between the gate and the source of the transistor 934 that is labelled as "Small N" in the drawing). The mirror factor M of the current mirror circuit 930 allows a large current on the second branch 933, and thus a fast turn-on of the short-circuit transistor 911.

The regulation control circuit 912 of Fig. 9 also enables low power consumption when the active VEE clamp is disabled after soft start.

In one or more of the examples disclosed herein, the shunt transistor and the short-circuit transistor can be implemented as the same transistor; i.e., a single transistor that performs the functionality of both the shunt transistor and the short-circuit transistor. This can be considered as hybrid driving. The single transistor can operate in a low ohmic mode when it receives the shunt control signal, and it can operate in a variable ohmic mode when it receives the shunt control signal.

In such hybrid driving, the shunt transistor and the short-circuit transistor can be provided by the same MOSFET (metal oxide semiconductor FET). We will now describe an example of hybrid driving with reference to the circuit that is shown in Fig. 9. During startup, pull-up driving circuit is working, EA (error amplifier) is disabled, and output is high impedance (HZ). Once the short is to be released, in order to transition to EA shunt, then we put EN=0 only on "Turn-off switch 1" while "Turn-off switch 2" must be removed / not pulling down the "SHORT" (now = SHUNT) MOS gate. To ensure HZ on the short gate, mirror should be secured to OFF state and also additional resistive path R2 should be removed. In the transition SHORT to SHUNT driving, Vgs will start from 5V and be pulled-down by the error amplifier.

Returning to Fig. 3, the following components are illustrated:

On the low voltage microprocessor (uP) side:

Primary side of flyback transformer;
External low side transistor to drive primary; and
Shunt resistor to sense primary current.

Integrated in Gate Driver Device:

Driver stage for the external low side transistor;
Gate Control Digital logic;
Current sense amplifier;
LV side control logic; and
Galvanic Communication Receiver.

On the high voltage (HV) inverter side:

Secondary side of flyback transformer; and
Diode and capacitors for dual rail isolated output voltage.

Integrated in Gate Driver Device:

Hysteretic Control VCC to GND;
VEEREG Shunt regulator to create the split rail supply;
Galvanic Communication Transmitter;
VCCREG LDO (post regulate the positive rail on the isolated side); and
Short Switch + Short Switch Driving Circuit.

At startup VCC=VEE=0, so the High Voltage (HV) die is not supplied. VCC LDO regulator is initially not supplied but it becomes supplied as soon as VCC reaches a high enough value (above VCC POR threshold, for instance) and before VCC reaches the full value needed in the system. On the contrary VEE increase is not allowing to supply the VEE regulator.

Soft Start initially occurs in open loop because of lack of power supply, but it is beneficial to keep VEE (flyback negative output) under control in order to avoid BOM components damage.

Examples disclosed herein include a short that is enabled and supplied as soon as flyback startup allows the integration of any VCC-VEE>0V on the output capacitances CVCC and CVEE.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A driver circuit for controlling a high-power switch, the driver circuit comprising:

   a flyback converter, comprising:

   a positive output rail, which is configured to provide a positive output voltage with reference to a ground terminal; and
   a negative output rail, which is configured to provide a negative output voltage with reference to the ground terminal;

   a driving stage that is connected between the positive output rail and the negative output rail, wherein the driving stage is configured to provide a high-power switch control signal for controlling the state of the high-power switch;
   a shunt regulator configured to regulate the negative output voltage on the negative output rail based on a difference between the negative output voltage and a target negative voltage value, wherein the shunt regulator is powered by the positive output voltage on the positive output rail;
   a short-circuit transistor having:

   a conduction channel that is connected between the negative output rail and the ground terminal, and
   a control terminal; and

   a regulation control circuit configured to:
   provide a short-circuit control signal to the control terminal of the short-circuit transistor in order to short the negative output rail to the ground terminal until the positive output voltage reaches a positive threshold.

2. The driver circuit of claim 1, wherein the positive threshold is sufficient for powering the shunt regulator.

3. The driver circuit of claim 1, wherein the shunt regulator comprises an error amplifier, which is configured to compare the negative output voltage to the target negative voltage value, and wherein the error amplifier is powered by the positive output voltage on the positive output rail.

4. The driver circuit of claim 3, wherein:

   the shunt regulator further comprises a shunt transistor, wherein the shunt transistor comprises: a conduction channel that is connected between the negative output rail and the ground terminal; and a control terminal; and
   the error amplifier circuit is configured to provide a shunt control signal to the control terminal of the shunt transistor, wherein the shunt control signal is representative of the difference between a reference voltage and the negative output voltage.

5. The driver circuit of claim 4, wherein:

   the shunt transistor is configured to operate in an ohmic mode, having a variable ohmic value that depends on the shunt control signal; and
   the short-circuit transistor is configured to operate in a low ohmic mode.

6. The driver circuit of claim 5, wherein the shunt transistor and the short-circuit transistor are implemented as a single transistor.

7. The driver circuit of claim 6, wherein the single transistor is configured to operate in a low ohmic mode when it receives the short control signal, and is configured to operate in a variable ohmic mode when it receives the shunt control signal.

8. The driver circuit of any preceding claim, wherein: the regulation control circuit comprises:

   a pull up resistor connected between the positive output rail and the control terminal of the short-circuit transistor;
   a Zener diode comprising an anode and a cathode, wherein the cathode is connected to the control terminal of the short-circuit transistor and the anode is connected to the negative output rail; and
   an internal disable transistor comprising a conduction channel connected between the negative output rail and the control terminal of the short-circuit transistor, and a control terminal configured to receive an internal disable signal.

9. The driver circuit of any preceding claim, wherein the regulation control circuit further comprises:
   an external disable transistor comprising a conduction channel connected between the negative output rail and the control terminal of the short-circuit transistor, and a control terminal configured to receive an external disable signal.

10. The driver circuit of claim 9, wherein the external disable signal is provided based on a user input.

11. The driver circuit of any preceding claim, wherein the regulation control circuit further comprises a current mirror, wherein the current mirror comprises:

a first branch, which includes a resistor in series with the conduction channel of a first internal disable transistor;
a second branch, which includes the conduction channel of a second internal disable transistor;

wherein:

the first branch is connected between the positive output rail and the negative output rail;
the second branch is connected between the positive output rail and the negative output rail;
the conduction channel of the second internal disable transistor is connected between the control terminal of the short-circuit transistor and the negative output rail;
the first and the second internal disable transistors are configured to receive an internal disable signal; and
the time constant of the first branch is less than the time constant of the second branch.

12. The driver circuit of any preceding claim, wherein when the driver circuit is switched on, the positive output voltage increases until it reaches a first setpoint threshold, at which time the driver circuit is configured to wait for a user input for defining a value of a second setpoint threshold, wherein after the driver circuit receives the user input, the positive output voltage increases until it reaches the second setpoint threshold.

FIG. 1

FIG. 2

FIG. 3

FIG. 4

FIG. 5

FIG. 6

FIG. 7

FIG. 8

FIG. 9

## EUROPEAN SEARCH REPORT

**Application Number**

EP 24 17 3084

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/030516 A1 (MURATA MANUFACTURING CO [JP] ET AL.) 14 February 2019 (2019-02-14)<br>* page 1, lines 24-30; figures 3,4 *<br>* page 5, lines 18-36 *<br>* page 12, line 9 - page 17, line 14 *<br>----- | 1-12 | INV.<br>H03K17/041<br>H02M1/00<br>H02M1/08<br>H02M3/335<br>H03K17/06 |
| A | WO 2021/019218 A1 (MURATA MANUFACTURING CO [JP] ET AL.) 4 February 2021 (2021-02-04)<br>* page 7, line 12 - page 8, line 32; figure 5 *<br>* page 13, line 18 - page 16, line 23; figure 8 *<br>----- | 1-12 | |
| A | WO 2022/074378 A1 (MURATA MANUFACTURING CO [JP] ET AL.) 14 April 2022 (2022-04-14)<br>* the whole document *<br>----- | 1-12 | |
| A | WO 2022/129940 A1 (MURATA MANUFACTURING CO [JP] ET AL.) 23 June 2022 (2022-06-23)<br>* the whole document *<br>----- | 1-12 | TECHNICAL FIELDS SEARCHED (IPC)<br><br>H03K<br>H02M |

The present search report has been drawn up for all claims

| Place of search | Date of completion of the search | Examiner |
|---|---|---|
| The Hague | 17 September 2024 | João Carlos Silva |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 17 3084

17-09-2024

| Patent document cited in search report | Publication date | Patent family member(s) | | Publication date |
|---|---|---|---|---|
| WO 2019030516 A1 | 14-02-2019 | CN | 110999053 A | 10-04-2020 |
| | | DE | 112018003431 T5 | 02-04-2020 |
| | | GB | 2565297 A | 13-02-2019 |
| | | US | 2020177087 A1 | 04-06-2020 |
| | | WO | 2019030516 A1 | 14-02-2019 |
| WO 2021019218 A1 | 04-02-2021 | GB | 2586049 A | 03-02-2021 |
| | | US | 2022149835 A1 | 12-05-2022 |
| | | WO | 2021019218 A1 | 04-02-2021 |
| WO 2022074378 A1 | 14-04-2022 | GB | 2599893 A | 20-04-2022 |
| | | US | 2023238892 A1 | 27-07-2023 |
| | | WO | 2022074378 A1 | 14-04-2022 |
| WO 2022129940 A1 | 23-06-2022 | CN | 116601858 A | 15-08-2023 |
| | | GB | 2602127 A | 22-06-2022 |
| | | US | 2023327540 A1 | 12-10-2023 |
| | | WO | 2022129940 A1 | 23-06-2022 |

EPO FORM P0459